# EUROPEAN PATENT APPLICATION

(11) **EP 4 599 945 A1**
(43) Date of publication of application: **13.08.2025**
(21) Application number: 24832068.1
(22) Date of filing: 28.06.2024
(51) Int. Cl.: B05D 1/26, B05C 5/00, B05C 11/00, B05C 11/10, B05C 13/02, B05D 7/00, B05D 7/22

(54) **LIQUID COATING METHOD AND LIQUID COATING DEVICE**

(30) Priority: 30.06.2023 JP 2023107909
(71) Applicant: Musashi Engineering, Inc., Mitaka-shi, Tokyo 181-0011 (JP)
(72) Inventor: IKUSHIMA, Kazumasa, Mitaka-shi, Tokyo 181-0011 (JP)
(74) Representative: TBK
(86) International application number: PCT/JP2024/023446
(87) International publication number: WO 2025/005210

(57) **Abstract**

Problem: To solve a problem of deterioration in application quality that occurs in a case where a width of a recessed application area changes between a start point and an end point of an application route.

Solution: Provided is a liquid application method for filling, with liquid material, an application area made up of gaps between an inner wall surface of a recess 201 of a workpiece 111 and outer peripheries of components 202, 203 disposed in the recess 201, the application method including: a position acquisition step of acquiring position coordinates of the components 202, 203 based on captured images including feature portions of the components 202, 203; an application route setting step of setting, based on the position coordinates, an application area and an application route for a discharge device 102 to perform application; an application parameter setting step of segmenting the application route of the discharge device 102 into application route segments based on the position coordinates and setting an application amount for each application route segment; and an application step of applying the liquid material to the application area while moving the discharge device 102 along the application route. Also provided is a liquid application apparatus that executes the liquid application method.

## Description

### Technical Field

The present invention relates to a liquid application method and a liquid application apparatus. Particularly, it relates to a liquid application method and a liquid application apparatus for filling, with liquid material, an application area made up of a gap between an inner wall surface of a recess and an outer periphery of a component.

### Background Art

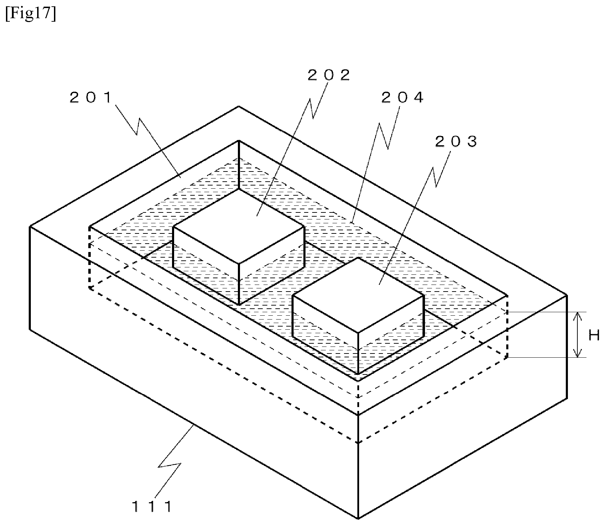

There is a step of fixing a plurality of electronic components (for example, semiconductor elements) through filling, with liquid material, an area around the components installed in a recess provided in a board and curing the liquid material (for example, see Fig. 17). In this step, there is an issue that variation in installation positions of electronic components hampers proper filling with liquid material.

As an apparatus that performs application depending on the variation in the installation positions of electronic components, for example, Patent Document 1 discloses a paste application apparatus which recognizes a positional relationship between a board and an electronic component and controls a nozzle to apply a paste in a paste pattern of a desired shape based on the positional relationship.

As an apparatus that performs filling depending on a shape of an area to be filled, for example, Patent Document 2 discloses a filling apparatus that includes: a means for measuring a joint width with a CCD camera; and a means for changing a discharge amount of a caulking agent depending on an amount of variation in the joint width, and performs filling with the caulking agent while moving along a joint in wall materials.

### Prior Art List

### Patent Document

Patent Document 1: Japanese Patent Laid-Open Publication No. 2011-177652
Patent Document 2: Japanese Patent Laid-Open Publication No. 2002-364168

### Summary of the Invention

### Problems to be Solved by the Invention

In a case where a width of a recessed application area changes between a start point and an end point of an application route, there has been an issue that discharging liquid material under a constant condition causes an excess or shortage of application amount at some portions, leading to deterioration in quality. Neither Patent Document 1 nor Patent Document 2 discloses an application method for the case where a width of an application area changes between a start point and an end point of an application route.

An object of the present invention is to provide a liquid application method and a liquid application apparatus that can perform filling with an appropriate amount of liquid material even in the case where a width of a recessed application area changes between a start point and an end point of an application route.

### Means for Solving the Problems

[1] An application method according to the present invention is an application method for filling, with liquid material, an application area made up of a gap between an inner wall surface of a recess of a workpiece and an outer periphery of a component disposed in the recess, the application method including: a position acquisition step of acquiring position coordinates of the component based on a captured image including a feature portion of the component; an application route setting step of setting, based on the position coordinates, an application area and an application route for a discharge device to perform application; an application parameter setting step of segmenting the application route of the discharge device into application route segments based on the position coordinates and setting an application amount for each application route segment; and an application step of applying the liquid material to the application area while moving the discharge device along the application route.
[2] In the application method according to [1], in the application route setting step, the application area may be segmented into application area segments and the application route segment may be set for each application area segment.
[3] In the application method according to [2], the component may be one of a plurality of components disposed at intervals in the same recess, and the application area may include a portion between the plurality of components.
[4] In the application method according to [2] or [3], the recess may have a polygonal shape as viewed from above, the component may have a polygonal shape as viewed from above, and in the position acquisition step, position coordinates of all corners of the component and position coordinates of corners of the recess close to each corner of the component may be acquired.
[5] In the application method according to [4], in the application route setting step, the application area may be segmented into application area segments of which vertices include corners of the component.
[6] In the application method according to [4] or [5], in the application route setting step, the application area may be segmented into a plurality of application area segments made up of quadrangles.
[7] In the application method according to any one of [4] to [6], in the application route setting step, the application route may be set with a straight route passing through a middle point of a width of the application area segment in a direction perpendicular to a traveling direction of the application route.
[8] The application method according to any one of [2] to [7] may include an initial setting step of setting an initial application area, an initial application route, an initial application amount, and a reference correction amount, executed prior to the position acquisition step. In the application parameter setting step, the application amount may be set for each application area segment based on an application amount calculated based on a shape of the application area segment and the reference correction amount.
[9] In the application method according to any one of [2] to [8], in the application parameter setting step, in a case where a width of the application area segment in a direction perpendicular to a traveling direction of the application route is different between a start point and an end point, the application area segment may be segmented into application area sub-segments, and an application amount may be set for each application area sub-segment.
[10] In the application method according to any one of [2] to [9], in the application parameter setting step, the application amount may be set by, with a discharge amount per unit time of the discharge device kept constant, setting a relative movement speed between the discharge device and the workpiece for each application area segment.
[11] In the application method according to any one of [2] to [10], in the application parameter setting step, the application amount may be set by setting any one or more of following [A] to [D]:
   [A] in a case where the discharge device is a jet-type discharge device, a number of times of discharge per unit time;
   [B] in a case where the discharge device is a screw-type discharge device, a rotation speed of a screw;
   [C] in a case where the discharge device is a plunger-type discharge device, a movement speed of a plunger; and
   [D] in a case where the discharge device is an air-type discharge device, pressure application time.
[12] In the application method according to any one of [2] to [11], the component may be a semiconductor element.
[13] In the application method according to any one of [2] to [12], in the application route setting step, an application height may be set to a height that does not reach a top end of either of the recess and the component.
[14] In the application method according to any one of [1] to [13], in the position acquisition step, position coordinates of the recess may be further acquired based on a captured image including a feature portion of the recess, and in the application parameter setting step, the application route of the discharge device may be segmented into application route segments based on the position coordinates of the recess and the component, and an application amount may be set for each application route segment.
[15] An application apparatus according to the present invention is an application apparatus including: a discharge device configured to discharge liquid material; a worktable on which a workpiece having a recess is placed; a relative driving device configured to move the discharge device and the worktable relative to each other; an image capturing device configured to capture an image including a feature portion of a component disposed with a gap in the recess of the workpiece; and a control device configured to control operation of the discharge device, the relative driving device, and the image capturing device. The control device includes: a position acquisition means configured to acquire position coordinates of the component based on the captured image; an application route setting means configured to set an application route of the discharge device based on the position coordinates; an application parameter setting means configured to segment the application route of the discharge device into application route segments based on the position coordinates and set an application amount for each application route segment; and an application means configured to apply the liquid material to the gap while moving the discharge device along the application route.
[16] In the application apparatus according to [15], the application route setting means may be configured to segment an application area based on the position coordinates into application area segments, and set the application route segment for each application area segment.
[17] In the application apparatus according to [16], the application parameter setting means may be configured to, in a case where a width of the application area segment in a direction perpendicular to a traveling direction of the application route is different between a start point and an end point, segment the application area segment into application area sub-segments, and set an application amount for each application area sub-segment.
[18] The application apparatus according to any one of [15] to [17] may further include a ranging device configured to measure a distance to the workpiece or the component.
[19] The application apparatus according to any one of [15] to [18] may further include a calibration device including a trial application area and a weighing instrument. Advantageous Effect of the Invention

According to the present invention, it is possible to perform filling with an appropriate amount of liquid material even in a case where a width of a recessed application area changes between a start point and an end point of an application route.

### Brief Description of the Drawings

[Fig. 1] Fig. 1 is a flowchart of a procedure for initial setting according to embodiments.
[Fig. 2] Fig. 2 is a flowchart of a procedure for setting reference images and image capturing position coordinates.
[Fig. 3] Fig. 3 is a flowchart of a procedure for setting an initial application route.
[Fig. 4] Fig. 4 is a flowchart of a procedure for setting initial application parameters.
[Fig. 5] Fig. 5 is a flowchart of an application step according to embodiments.
[Fig. 6] Fig. 6 is a flowchart of a procedure for component misalignment detection processing.
[Fig. 7] Fig. 7 is a flowchart of a procedure for setting a corrected application route.
[Fig. 8] Fig. 8 is a flowchart of a procedure for modifying the application parameters.
[Fig. 9] Fig. 9 is a flowchart of a correction procedure in a case where a width of an application area segment is not constant.
[Fig. 10] Fig. 10 is a diagram illustrating profile feature portions and an application area according to embodiments.
[Fig. 11] Fig. 11 is a diagram illustrating setting of the initial application route according to embodiments.
[Fig. 12] Fig. 12 is a diagram illustrating variation in component installation positions according to embodiments.
[Fig. 13] Fig. 13 is a diagram illustrating setting of the corrected application route according to embodiments.
[Fig. 14] Fig. 14 is a diagram illustrating a method for correcting application parameters for an application area segment Q11 having a non-constant width.
[Fig. 15] Fig. 15 is a diagram illustrating a method for correcting application parameters for an application area segment Q15 having a non-constant width.
[Fig. 16] Fig. 16 is a perspective view of an application apparatus according to embodiments.
[Fig. 17] Fig. 17 is a perspective view illustrating a board having a recess to be filled with liquid material.

### Mode for Carrying out the Invention

Embodiments of the present invention will be described below.

A liquid application method according to the present invention is performed on a workpiece including a member with a recess and one or more components disposed in the recess. The member with a recess is, for example, a board or a block-shaped member, and the recess has a shape of a triangle, polygon with four or more sides, circle, ellipse, or the like as viewed from above. The component disposed in the recess is, for example, an electronic component having a shape of a triangle, polygon with four or more sides, circle, ellipse, or the like as viewed from above.

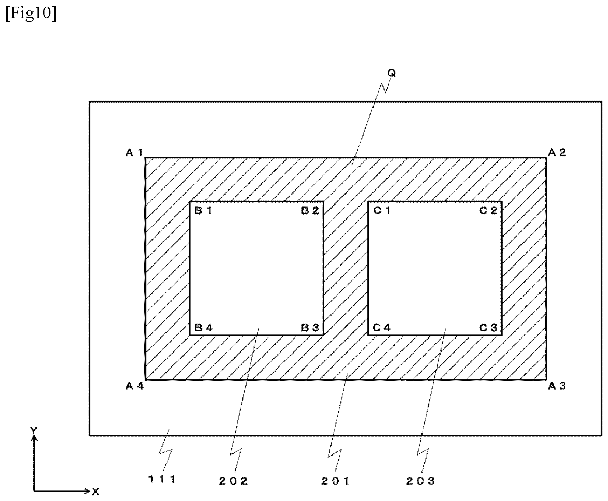

An embodiment of the present invention will be described using, as an example, a case where two rectangular components (202, 203) (for example, semiconductor elements) are installed in a rectangular recess 201 provided in a board 111 as illustrated in Fig. 10.

### <Application Method>

In an application method according to this embodiment, first, an initial setting step is performed, and thereafter an application step is carried out. Details will be described below.

### (1) Initial Setting Step

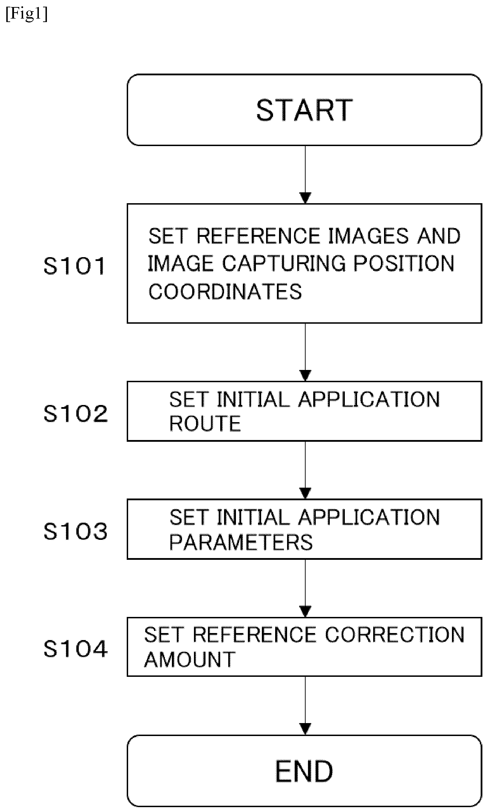

Prior to carrying out application, initial setting necessary for the application is performed. As illustrated in Fig. 1, the initial setting step mainly includes setting reference images and image capturing position coordinates (S101), setting an initial application route (S102), setting initial application parameters (S103), and setting a reference correction amount (S104). Each step will be described in detail below.

### (1-1) Setting Reference Images and Image Capturing Position Coordinates (S101)

An application area Q according to this embodiment is an area surrounding whole peripheries of the components 202, 203 as viewed from above, that is, as illustrated in Fig. 10, a hatched area between the recess 201 of the board 111 and the components 202, 203. In order to define this application area Q, profile feature portions of the recess 201 of the board 111 and the components 202, 203 are extracted by image processing. Particularly, images are captured that include four corners A1 to A4 of the recess 201 of the board 111, four corners B1 to B4 of a first component 202, and four corners C1 to C4 of a second component 203, which serve as the profile feature portions, and coordinate values for them are determined by image processing.

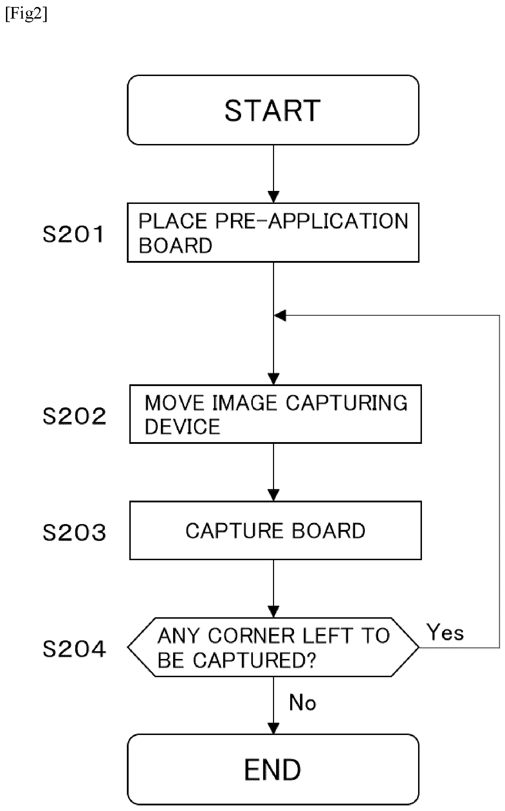

A procedure for setting reference images and image capturing position coordinates (S101) will be described with reference to Fig. 2.

(S201) A pre-application board 111 having a recess 201 in which components 202, 203 have been properly installed is placed on a worktable.

(S202) An image capturing device (camera) 122 is moved to an initial image capturing position such that a selected corner of the recess 201 or the component 202, 203 is centered on a screen. Note that the corners of the recess 201 or the component 202, 203 may be captured in any order.

(S203) An image of the board 111 is acquired by an image capturing device 122 and coordinate values (X, Y) with which the target corner is centered on the screen are stored in a storage device of a control device 113.

(S204) The processing S202 to S203 is repeated until images and coordinates have been acquired for all the corners of the recess 201 and the components 202, 203.

The images in which the corners are centered and the coordinate values of the image capturing device acquired in S202 to 204 serve as reference images used for image recognition to be described below and image capturing position coordinates for the image capturing device 122 to capture a board 111 as a target of application work.

Note that the board 111 used in S101 may be a board actually used in production or may be a specially prepared dummy board. Further, coordinate values of the corners of the recess 201 or the component 202, 203 may be calculated and set by utilizing dimensional data at the time of design.

### (1-2) Setting Initial Application Route (S102)

As illustrated in Fig. 10, when the corners of the recess 201 of the board 111 on which the initial setting is performed in S101 are denoted by A1 to A4, the corners of the left component 202 are denoted by B1 to B4, and the corners of the right component 203 are denoted by C1 to C4, a portion (hatched portion) surrounded by A1-A2-A3-A4 excluding portions surrounded by B1-B2-B3-B4 and C1-C2-C3-C4 is the application area Q. An application route of a discharge device 102 is set for this application area.

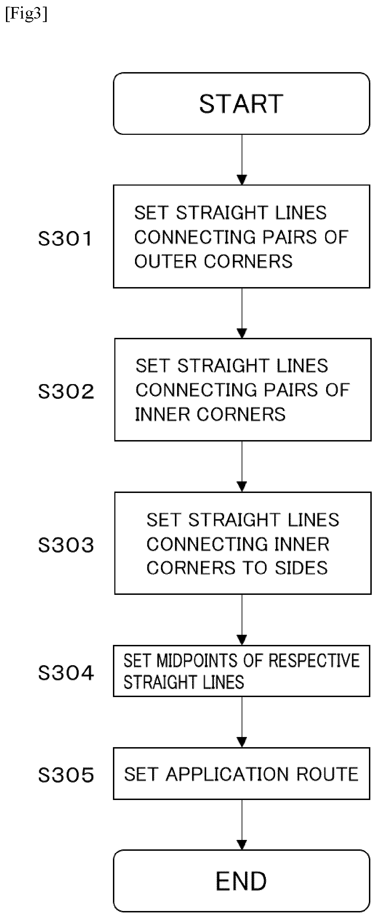

A procedure for setting an initial application route will be described with reference to Fig. 3.

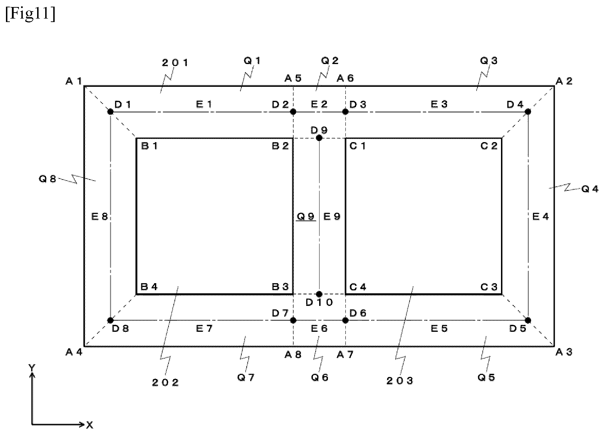

(S301) Straight lines are drawn between corners of the respective components on sides not facing each other, that is, outer corners (B1, B4, C2, C3) and corresponding corners (A1, A2, A3, A4) of the recess 201 closest to those corners. In the example of Fig. 11, four straight lines represented by dotted lines are drawn between A1 and B1, A2 and C2, A3 and C3, and A4 and B4 to segment the application area Q into a plurality of application area segments.

(S302) Straight lines are drawn between two closest corners respectively among corners of the respective components on adjacent sides, that is, inner corners (B2, B3, C1, C4). In the example of Fig. 11, two straight lines represented by dotted lines are drawn between B2 and C1, and B3 and C4 to segment the application area Q into a plurality of application area segments.

(S303) Perpendicular lines are drawn from the four inner corners (B2, B3, C1, C4), which are ends of the straight lines drawn in S302, toward corresponding two closest sides (A1-A2, A3-A4) of the recess 201. In the example of Fig. 11, four straight lines represented by dotted lines are drawn between B2 and A5, C1 and A6, C4 and A7, and B3 and A8, to segment the application area Q into a plurality of application area segments. In Fig. 11, intersection points between the respective perpendicular lines and the sides of the recess 201 are denoted by A5, A6, A7, and A8.

(S304) Points in the middle positions (hereinafter, referred to as "midpoints") of the respective straight lines (A1-B1, A2-C2, A3-C3, A4-B4, B2-C1, B3-C4, B2-A5, C1-A6, C4-A7, and B3-A8) drawn in S301 to S303 are calculated respectively. In the example of Fig. 11, ten midpoints D1 to D10 are set.

(S305) Unit application routes are set by connecting each midpoint calculated in S304 with straight lines. In this embodiment, nine unit application routes represented by dash-dotted lines in Fig. 11 are set. Further, a plurality of unit application routes on a common straight line are grouped, resulting in following five application route segments being set:
·first application route segment including straight lines E1, E2, and E3 connecting midpoints D1, D2, D3, and D4;
·second application route segment including a straight line E4 connecting midpoints D4 and D5;
·third application route segment including straight lines E5, E6, and E7 connecting midpoints D5, D6, D7, and D8;
·fourth application route segment including a straight line E8 connecting midpoints D8 and D1; and
·fifth application route segment including a straight line E9 connecting midpoints D9 and D10.

In this embodiment, for each application route segment, a start point and an end point are set as follows:
·in the first application route segment (E1-E2-E3), D1 is a start point and D4 is an end point;
·in the second application route segment (E4), D4 is a start point and D5 is an end point;
·in the third application route segment (E5-E6-E7), D8 is a start point and D5 is an end point;
·in the fourth application route segment (E8), D1 is a start point and D8 is an end point; and
·in the fifth application route segment (E9), D9 is a start point and D10 is an end point.

The procedure for setting an application route can be described as segmenting one extensive application area into a plurality of application area segments made up of quadrangles and setting the application route in units of the application area segments.

In this embodiment, unit application routes aligned in one direction (for example, an X-direction) are grouped and set as an application route segment. However, any other application route segment having its start point/end points may be set. For example, the start point/end points may be set for each of the unit application routes E1, E2, and E3, or an application route segment corresponding to a rectangular application area segment made up of areas Q2, Q9, and Q6 may be set. Alternatively, the start points and end points may be set such that all the unit application routes can be connected in one stroke.

A method for segmenting the application area into application area segments is not limited to the segmentation rules specified in S301 to S303, and an application area segment of any shape can be set. For example, instead of the segmentation rule of S301, application area segments may be set by drawing perpendicular lines from each corner of the components 202, 203 toward sides of the recess 201, so that all the application area segments have a rectangular shape.

### (1-3) Setting Initial Application Parameters (S103)

Initial application parameters are set for application to the application route set in S102. It is better to set the initial application parameters for each application route segment set above. Application areas corresponding to the unit application routes E1 to E9 are referred to as application area segments Q1 to Q9.

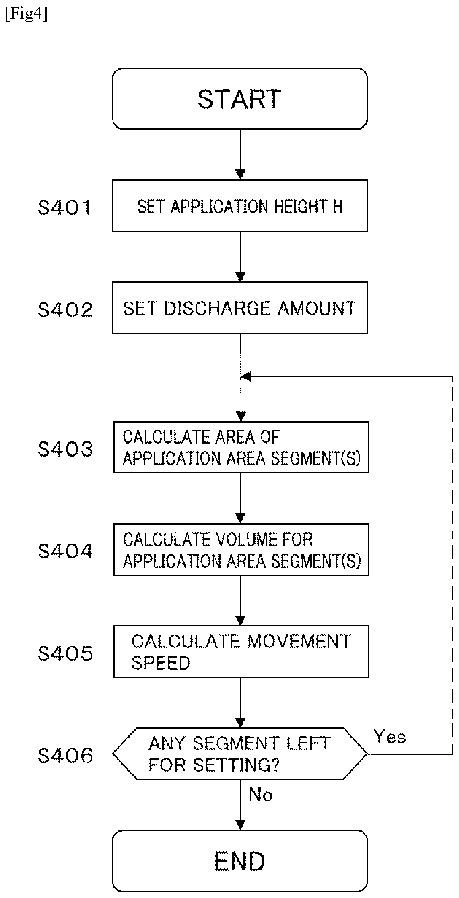

A procedure for setting initial application parameters will be described with reference to Fig. 4.

(S401) An application height H is set. As illustrated in Fig. 17, the application height H is set to a height that does not exceed a depth of the recess 201 and a height of the components 202, 203. Note that the application height H is the same for the application area segments Q1 to Q9.

(S402) A discharge amount (for example, volume) per unit time of the discharge device 102 is set. Here, the discharge amount per unit time may be set by measuring an amount discharged by the discharge device 102 during trial application.

(S403) A top-projected area of selected one or ones of the application area segments is calculated from the coordinate values of corners of the recess 201 and the components 202, 203 constituting the vertices of the selected application area segment(s).

(S404) A volume (application amount) for the selected application area segment(s) is calculated from the application height set in S401 and the area calculated in S403.

(S405) A movement speed of the discharge device 102 for a unit application route corresponding to the selected application area segment(s) is calculated from the discharge amount per unit time set in S402, the volume (application amount) calculated in S404, and a length of the unit application route. Note that the movement speed of the discharge device 102 is a relative movement speed between the discharge device 102 and the board 111. By adjusting the movement speed of the discharge device 102 of which discharge amount per unit time is constant, a desired application amount is realized.

(S406) The processing S403 to S405 is executed for all the application area segments.

The processing of setting initial application parameters in S403 to 405 will be explained using an example of the straight lines E1 to E9.

### • First application route segment (E1-E2-E3)

The top-projected area is calculated from the coordinate values of the corners A1, A2, B1, and C2 of a trapezoidal application area (Q1 + Q2 + Q3) corresponding to the first application route segment, and then the volume for the area that combines the application area segments Q1 to Q3 is calculated using the application height H. The movement speed of the discharge device 102 is calculated from the total volume for the application area segments Q1 to Q3, the preset discharge amount per unit time, and the length of the first application route segment (distance between the midpoints D1 and D4), and the initial application parameters are set.

### • Second application route segment (E4)

The top-projected area is calculated from the coordinate values of the corners A2, A3, C2, and C3 of a trapezoidal application area Q4 corresponding to the second application route segment, and then the volume for the application area segment Q4 is calculated using the application height H. The movement speed of the discharge device 102 is calculated from the volume for the application area segment Q4, the preset discharge amount per unit time, and the length of the second application route segment (distance between D4 and D5), and the initial application parameters are set.

### • Third application route segment (E5-E6-E7)

The top-projected area is calculated from the coordinate values of the corners A3, A4, B4, and C3 of a trapezoidal application area (Q5 + Q6 + Q7) corresponding to the third application route segment, and then the volume for the area that combines the application area segments Q5 to Q7 is calculated using the application height H. The movement speed of the discharge device 102 is calculated from the total volume for the application area segments Q5 to Q7, the preset discharge amount per unit time, and the length of the third application route segment (distance between D5 and D8), and the initial application parameters are set.

### • Fourth application route segment (E8)

The top-projected area is calculated from the coordinate values of the corners A1, A4, B1, and B4 of a trapezoidal application area Q8 corresponding to the fourth application route segment, and then the volume for the application area segment Q8 is calculated using the application height H. The movement speed of the discharge device 102 is calculated from the volume for the application area segment Q8, the preset discharge amount per unit time, and the length of the fourth application route segment (distance between D1 and D8), and the initial application parameters are set.

### • Fifth application route segment (E9)

The top-projected area is calculated from the coordinate values of the corners B2, B3, C1, and C4 of a rectangular application area Q9 corresponding to the fifth application route segment, and then the volume for the application area segment Q9 is calculated using the application height H. The movement speed of the discharge device 102 is calculated from the volume for the application area segment Q9, the preset discharge amount per unit time, and the length of the fifth application route segment (distance between D9 and D10), and the initial application parameters are set.

The procedure for calculating the movement speed of the discharge device 102 can be described as segmenting one extensive application area into a plurality of small application area segments, calculating the amount of the liquid material required for each application area segment, and setting parameters (the movement speed and the discharge amount per unit time of the discharge device) for applying that amount.

In this embodiment, each of the straight lines E1-E2-E3 and E5-E6-E7 can be considered as a single straight line without bends (in other words, no change in their widths) at the time of initial setting, and is thus treated as a single application route segment as a whole. However, straight lines each connecting two midpoints may be set as separate application route segments.

In this embodiment, although the volume per unit time of the discharge device 102 is used as the discharge amount per unit time, a mass (or weight) may be used instead of the volume. In a case where a density of the liquid material is known, the volume and the mass can be converted to each other. Further, instead of the discharge amount per unit time, a discharge amount per unit length of the discharge device 102 may be used.

In this embodiment, although the application height H is preset as a default, it may be set based on measured values obtained by actually measuring the depth of the recess 201 of the board 111 and the height of the components.

The application height H is set such that the liquid material does not flow onto top surfaces of the board and the components, in other words, to a height that does not exceed either of the depth of the recess 201 and the height of the components 202, 203 (see Fig. 17). The application height H is preferably set to a height obtained by subtracting a buffer height (for example, 10% or 20% of a lower value out of the depth of the recess 201 and the height of the components 202, 203) from the lower value out of the depth of the recess 201 and the height of the components 202, 203.

In this embodiment, although the movement speed of the discharge device 102 is calculated for each application route segment, the discharge amount per unit time of the discharge device 102 for realizing desired application may be calculated for each application route segment with the movement speed kept at a default (constant value).

### (1-4) Setting Reference Correction Amount (S104)

Setting initial application parameters is effective when components 202, 203 are disposed without misalignment, but actual installation positions of components 202, 203 are sometimes misaligned. Thus, in this embodiment, a reference correction amount is set in advance for correction depending on the variation in the installation positions of components 202, 203.

In this embodiment, a reference correction amount of the application amount with respect to increase/decrease in a width of the application area is set. For example, the reference correction amount of the application amount is set such that the application amount is increased/decreased by 0.1 mg for 0.5 mm increase/decrease in the width of the application area. With this setting, for example, when the width of the application area increases by 2 mm relative to a value in the initial setting, the application amount is increased by 0.4 mg, and when the width decreases by 1 mm relative to the value in the initial setting, the application amount is decreased by 0.2 mg.

### (2) Execution of Application Step

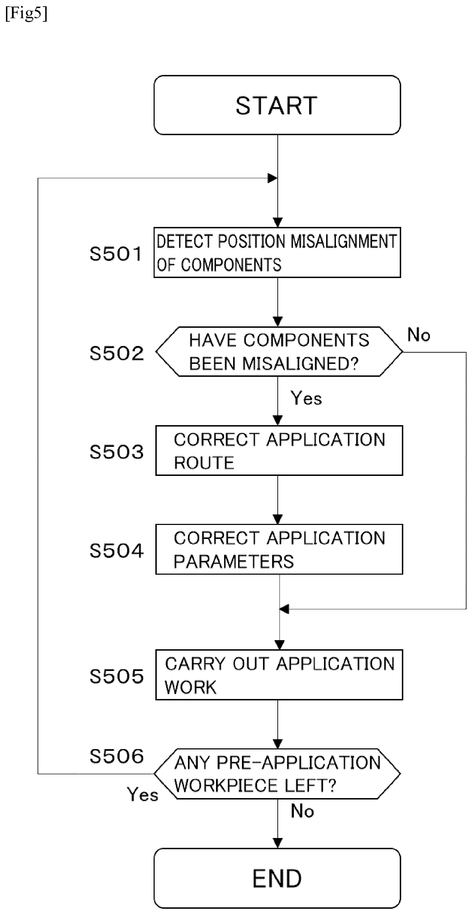

After the initial setting (S101 to S104) in (1) ends, the application step is started. As illustrated in Fig. 5, the execution of the application step mainly includes detection of component misalignment (S501), determination on component misalignment (S502), correction of an application route (S503), correction of application parameters (S504), and performing application work (S505). Each procedure described below is a procedure executed by the control device 113 executing an application program.

### (2-1) Detection of Component Misalignment (S501)

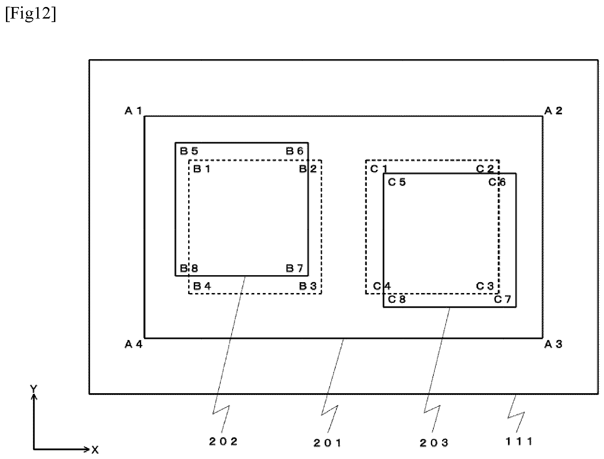

Prior to starting application on a board 111, whether the installation positions of components 202, 203 are misaligned is detected by performing image processing on images acquired by the image capturing device 122. Assume that, for example, as illustrated in Fig. 12, misalignment has occurred in which corners B1 to B4 are located at B5 to 8 due to misaligned installation of a left component 202, and corners C1 to C4 are located at C5 to 8 due to misaligned installation of a right component 203. When the installation positions of the components 202, 203 are misaligned in this way, the width of the application area is not constant and thus correction of the application route is required.

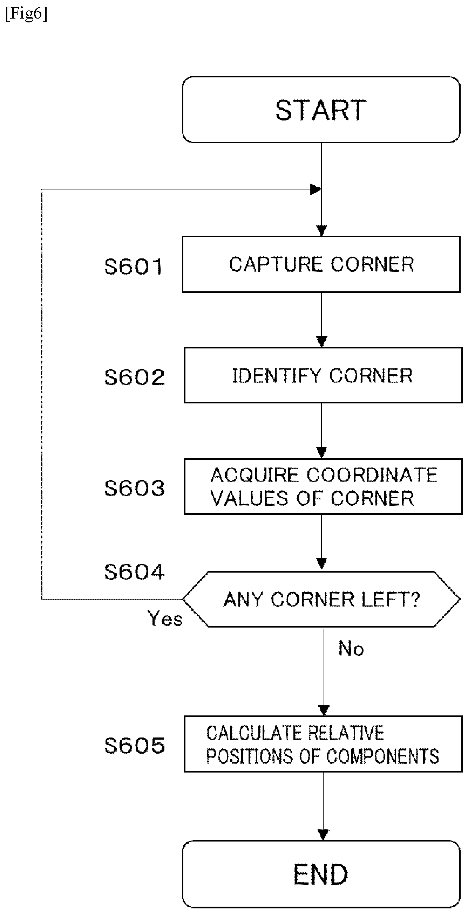

A procedure for component misalignment detection processing (S501) will be described with reference to Figs. 6 and 12. A board 111 on which application is performed has been transported into an application apparatus 101.

(S601) The image capturing device 122 is moved to one of the image capturing position coordinates set in S101, and one corner (for example, B5) of a recess 201 or a component 202, 203 is captured.

(S602) The image of the corner captured in S601 is compared with the reference image (for example, B1) set in S101 to identify the corresponding corner (for example, B5).

(S603) After identifying the corresponding corner (for example, B5) in S602, the coordinate values (X, Y) thereof are acquired and stored in the storage device of the control device 113.

(S604) The processing S601 to S603 is repeated for all the remaining corners of the recess 201 and the components 202, 203.

(S605) Relative positional relationships between the recess 201 and the components 202, 203 are determined from the acquired coordinate values of the corners of the recess 201 and the components 202, 203, and stored in the storage device. Herein, because installation position misalignment can occur not only in components 202, 203 but also in a recess 201, the relative positional relationships between the recess 201 and the components 202, 203 are determined.

### (2-2) Determination on Misalignment (S502)

Based on the detection results in S501, it is determined whether misalignment of the relative positional relationship between the recess 201 and the component 202, 203 exceeds a preset acceptable range. If the misalignment exceeds the acceptable range, the processing proceeds to S503. If the misalignment does not exceed the acceptable range, the processing proceeds to S505. Note that, if the misalignment is too large to be compensated for, the processing may be terminated and an alarm may be issued.

### (2-3) Correction of Application Route (S503)

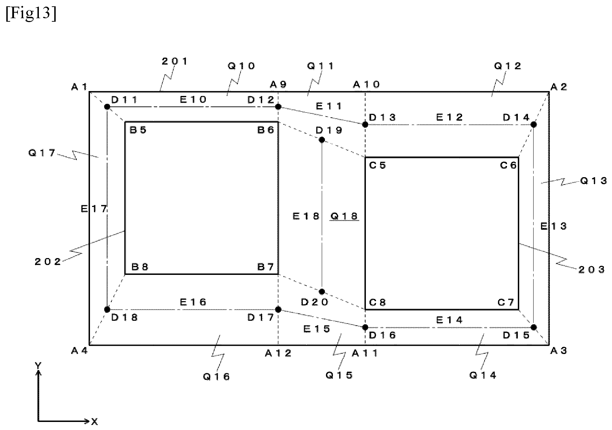

As illustrated in Fig. 12, in a case where the components 202, 203 are misaligned beyond the acceptable range, the application route needs to be corrected. This is because, as illustrated in Fig. 13, the width of the application area formed with the corners B5 to B8 of the component 202, the corners C5 to C8 of the component 203, and the corners A1 to A4 of the recess 201 of the board 111 is not constant with respect to each side of the recess 201. That is, the application route (E1 to E8) of the initial setting in Fig. 11 needs to be corrected to an application route (E10 to E17) illustrated in Fig. 13 depending on the misalignment of the components 202, 203.

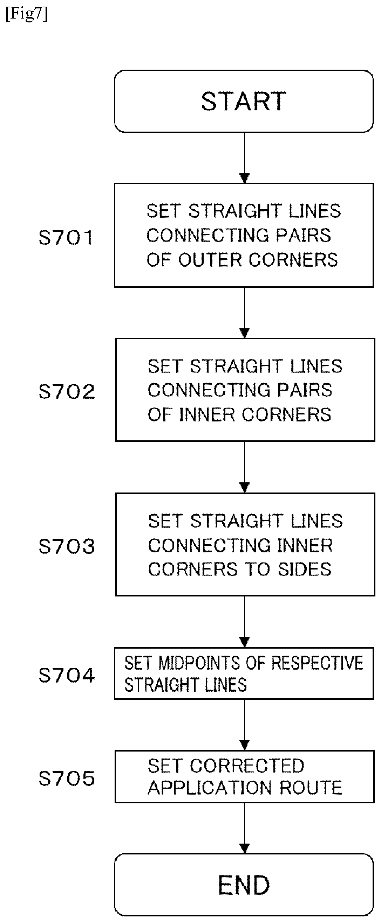

A procedure for correcting an application route (S503) will be described with reference to Fig. 7. Note that a procedure for setting unit application routes having been corrected (hereinafter, referred to as "corrected unit application routes") is similar to the procedure for setting an initial application route illustrated in Fig. 3.

(S701) Straight lines are drawn between corners of the components 202, 203 on sides not facing each other, that is, outer corners (B5, B8, C6, C7) and corresponding corners (A1, A2, A3, A4) of the recess 201 closest to those corners. In the example of Fig. 13, four straight lines represented by dotted lines are drawn between A1 and B5, A2 and C6, A3 and C7, and A4 and B8 to segment the application area Q into a plurality of application area segments.

(S702) Straight lines are drawn between corners closest to each other respectively among corners (B6, B7, C5, C8) of the respective components on adjacent sides. In the example of Fig. 13, two straight lines represented by dotted lines are drawn between B6 and C5, and B7 and C8 to segment the application area Q into a plurality of application area segments.

(S703) Perpendicular lines are drawn from the four inner corners (B6, B7, C5, C8), which are ends of the straight lines drawn in S702, toward corresponding two closest sides (A1-A2, A3-A4) of the recess. In the example of Fig. 13, four straight lines represented by dotted lines are drawn between B6 and A9, C5 and A10, C8 and A11, and B7 and A12 to segment the application area Q into a plurality of application area segments. In Fig. 13, intersection points between the respective perpendicular lines and the sides of the recess 201 are denoted by A9, A10, A11, and A12.

(S704) Points in the middle positions (midpoints) of the respective straight lines (A1-B5, A2-C6, A3-C7, A4-B8, B6-C5, B7-C8, B6-A9, C5-A10, C8-A11, and B7-A12) drawn in S701 to S703 are calculated respectively. In the example of Fig. 13, ten midpoints D11 to D20 are set.

(S705) Corrected unit application routes are set by connecting each midpoint calculated in S704 with straight lines. In this embodiment, nine corrected unit application routes represented by dash-dotted lines in Fig. 13 are set. Further, following five corrected application route segments are set by grouping a plurality of corrected unit application routes aligned substantially in one direction:
- first corrected application route segment including straight lines E10, E11, and E12 connecting midpoints D11, D12, D13, and D14;
- second corrected application route segment including a straight line E13 connecting midpoints D14 and D15;
- third corrected application route segment including straight lines E14, E15, and E16 connecting midpoints D15, D16, D17, and D18;
- fourth corrected application route segment including a straight line E17 connecting midpoints D18 and D11; and
- fifth corrected application route segment including a straight line E18 connecting midpoints D19 and D20.

In this embodiment, for each corrected application route segment, a start point and an end point are set as follows:
- in the first corrected application route segment (E10-E11-E12), D11 is a start point and D14 is an end point;
- in the second corrected application route segment (E13), D14 is a start point and D15 is an end point;
- in the third corrected application route segment (E14-E15-E16), D18 is a start point and D15 is an end point;
- in the fourth corrected application route segment (E17), D11 is a start point and D18 is an end point; and
- in the fifth corrected application route segment (E18), D19 is a start point and D20 is an end point.

The procedure for correcting an application route can be described as segmenting one extensive application area into a plurality of small application area segments and correcting the application route in units of the application area segments.

According to the procedure described above, even when installation position misalignment or a profile tolerance of the components 202, 203 has caused the application area to have a bend, wide and narrow portions, or the like, by setting an application route that is aligned with the shape of the application area, it is possible to perform filling with the liquid material without excess or shortage. In addition, the application route is set by connecting the midpoints of the lines segmenting the application area, and thus it passes almost through the middle of the application area. Therefore, the application area made up of gaps between the recess 201 and the components 202, 203 can be uniformly filled with the liquid material.

In this embodiment, although the application route is set as illustrated in Fig. 13, any application route other than this may be set as described in connection with the initial setting (see S102 above). In addition, the start points and end points may be arbitrarily set as well.

Further, the processing of drawing lines connecting sides and corners of the recess 201 to corners of the components 202, 203 (in other words, lines segmenting the application area) is not limited to the processing S701 to S703, and any drawing method may be adopted as described in connection with the initial setting (see S102 above).

### (2-4) Correction of Application Parameters (S504)

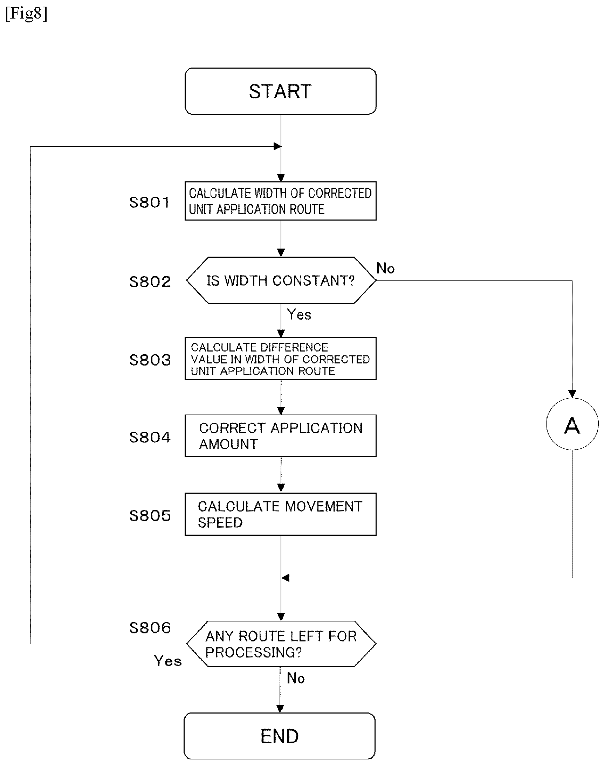

A procedure for correcting initially-set application parameters will be described with reference to Fig. 8.

(S801) A width of an application area segment including a selected one of the corrected unit application routes in a direction perpendicular to the corrected unit application route is calculated from the coordinate values of the corners of the corresponding application area segment. Here, as for the selection from the corrected unit application routes, any corrected unit application route may be selected.

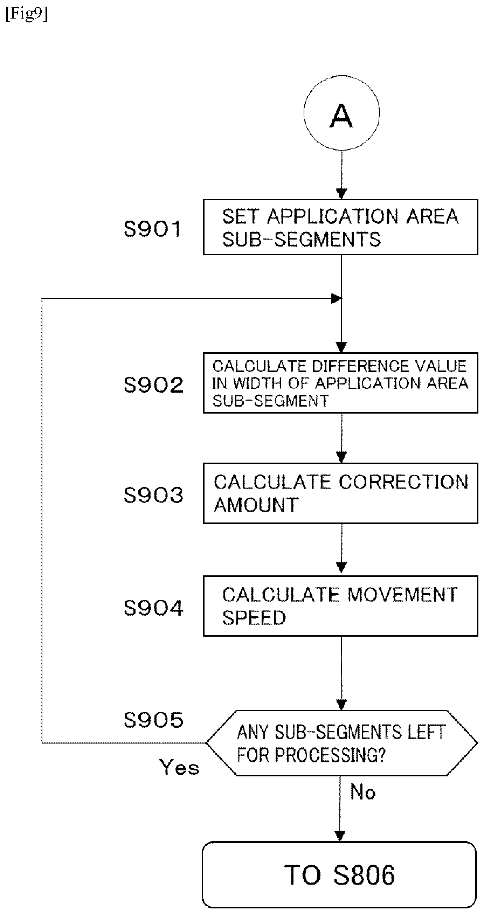

(S802) If the width at the start point of the selected one of the corrected unit application routes is the same as that at the end point, the processing proceeds to S803, and if they are different, the processing proceeds to a process A illustrated in Fig. 9.

(S803) A difference value between the width of the application area segment calculated in S801 and the width of the corresponding application area segment at the time of initial setting is calculated.

(S804) The application amount initially set for the application area segment is corrected based on the difference value in the width of the application area segment calculated in S803 and the reference correction amount set in S104.

(S805) The movement speed of the discharge device 102 is calculated from the application amount corrected in S804, the discharge amount per unit time set in S402, and the length of the selected corrected unit application route, and the application parameter(s) is corrected. The application parameter(s) to be corrected may be only the parameter related to the movement speed of the discharge device 102, or may include a discharge adjustment parameter depending on a type of the discharge device described below.

(S806) The processing S801 to S805 is repeated for all the corrected unit application routes.

The processing of correcting application parameters in S801 to 805 will be explained using an example of the routes E10, 12 to 14, and 16 to 18 illustrated in Fig. 13. Hereinafter, X( ) represents an X-coordinate, and Y( ) represents a Y-coordinate.

### • Corrected Unit Application Route E10

The width Y(A9) - Y(B6) of an application area segment Q10 including the corrected unit application route E10 in the direction perpendicular to the corrected unit application route E10 is calculated, and the difference value between the calculated width and the width Y(A5) - Y(B2) of the corresponding application area segment Q1 at the time of initial setting (see Fig. 11) is calculated. Based on this difference value and the reference correction amount set in S104, the application amount initially set in S103 is corrected. The movement speed of the discharge device 102 is calculated from this corrected application amount, the discharge amount per unit time set in S103, and the length X(D12) - X(D11) of the corrected unit application route E10, and the application parameter(s) is modified for the corrected unit application route E10.

### • Corrected Unit Application Route E12

The width Y(A10) - Y(C5) of an application area segment Q12 including the corrected unit application route E12 in the direction perpendicular to the corrected unit application route E12 is calculated, and the difference value between the calculated width and the width Y(A6) - Y(C1) of the corresponding application area segment Q3 at the time of initial setting (see Fig. 11) is calculated. Based on this difference value and the reference correction amount set in S104, the application amount initially set in S103 is corrected. The movement speed of the discharge device 102 is calculated from this corrected application amount, the discharge amount per unit time set in S103, and the length X(D14) - X(D13) of the corrected unit application route E12, and the application parameter(s) is modified for the corrected unit application route E12.

### • Corrected Unit Application Route E13

The width X(A2) - X(C6) of an application area segment Q13 including the corrected unit application route E13 in the direction perpendicular to the corrected unit application route E13 is calculated, and the difference value between the calculated width and the width X(A2) - X(C2) of the corresponding application area segment Q4 at the time of initial setting (see Fig. 11) is calculated. Based on this difference value and the reference correction amount set in S104, the application amount initially set in S103 is corrected. The movement speed of the discharge device 102 is calculated from this corrected application amount, the discharge amount per unit time set in S103, and the length Y(D14) - Y(D15) of the corrected unit application route E13, and the application parameter(s) is modified for the corrected unit application route E13.

### • Corrected Unit Application Route E14

The width Y(C8) - Y(A11) of an application area segment Q14 including the corrected unit application route E14 in the direction perpendicular to the corrected unit application route E14 is calculated, and the difference value between the calculated width and the width Y(C4) - Y(A7) of the corresponding application area segment Q5 at the time of initial setting (see Fig. 11) is calculated. Based on this difference value and the reference correction amount set in S104, the application amount initially set in S103 is corrected. The movement speed of the discharge device 102 is calculated from this corrected application amount, the discharge amount per unit time set in S103, and the length X(D15) - X(D16) of the corrected unit application route E14, and the application parameter(s) is modified for the corrected unit application route E14.

### • Corrected Unit Application Route E16

The width Y(B7) - Y(A12) of an application area segment Q16 including the corrected unit application route E16 in the direction perpendicular to the corrected unit application route E16 is calculated, and the difference value between the calculated width and the width Y(B3) - Y(A8) of the corresponding application area segment Q7 at the time of initial setting (see Fig. 11) is calculated. Based on this difference value and the reference correction amount set in S104, the application amount initially set in S103 is corrected. The movement speed of the discharge device 102 is calculated from this corrected application amount, the discharge amount per unit time set in S103, and the length X(D17) - X(D18) of the corrected unit application route E16, and the application parameter(s) is modified for the corrected unit application route E16.

### • Corrected Unit Application Route E17

The width X(B8) - X(A4) of an application area segment Q17 including the corrected unit application route E17 in the direction perpendicular to the corrected unit application route E17 is calculated, and the difference value between the calculated width and the width X(B4) - X(A4) of the corresponding application area segment Q8 at the time of initial setting (see Fig. 11) is calculated. Based on this difference value and the reference correction amount set in S104, the application amount initially set in S103 is corrected. The movement speed of the discharge device 102 is calculated from this corrected application amount, the discharge amount per unit time set in S103, and the length Y(D11) - Y(D18) of the corrected unit application route E17, and the application parameter(s) is modified for the corrected unit application route E17.

### • Corrected Unit Application Route E18

The width X(C5) - X(B6) of an application area segment Q18 including the corrected unit application route E18 in the direction perpendicular to the corrected unit application route E18 is calculated, and the difference value between the calculated width and the width X(C1) - X(B2) of the corresponding application area segment Q9 at the time of initial setting (see Fig. 11) is calculated. Based on this difference value and the reference correction amount set in S104, the application amount initially set in S103 is corrected. The movement speed of the discharge device 102 is calculated from this corrected application amount, the discharge amount per unit time set in S103, and the length Y(D19) - Y(D20) of the corrected unit application route E18, and the application parameter(s) is modified for the corrected unit application route E18.

A correcting procedure in a case where the width of an application area segment in the direction perpendicular to the application route is not constant will be described with reference to Fig. 9.

(S901) A selected one of the application area segments is further segmented into some small areas (hereinafter, referred to as "application area sub-segments").

(S902) A difference value between a start-side width and an end-side width of the selected one of the application area sub-segments is calculated.

(S903) A correction amount of the application amount for the selected application area sub-segment is calculated based on the difference value calculated in S902 and the reference correction amount set in S104.

(S904) The movement speed of the discharge device 102 is calculated from an application amount obtained by applying the correction amount calculated in S903 to the application amount for the application area sub-segment under the assumption that the start-side width is unchanged and constant, the discharge amount per unit time set in S103, and the length of the corrected application route segment, and the application parameter(s) is corrected.

(S905) The processing S902 to 904 is executed for all the application area sub-segments. When the application parameter(s) has been corrected for all the application area sub-segments, the processing returns to S806.

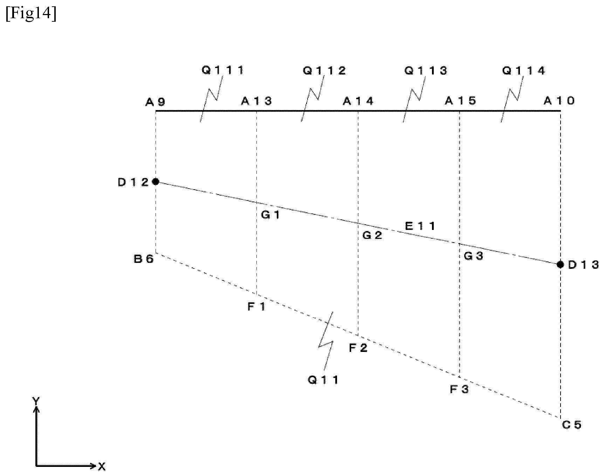

The processing of modifying application parameters in S901 to 905 will be explained using an example of the corrected unit application routes E11, and 15 with reference to Fig. 14.

### • Corrected Unit Application Route E11

Fig. 14 is an enlarged view of an application area segment Q11 corresponding to the corrected unit application route E11.

The application area segment Q11 is segmented in a direction perpendicular to a side A9-A10 of the recess 201 into four sub-segments such that their widths in the X-direction are the same. The four sub-segments created by the segmentation are referred to as application area sub-segments Q111 to 114. Herein, intersections between the side A9-A10 of the recess 201 and segmentation lines of the application area sub-segments Q111 to 114 are denoted by A13, A14, and A15, intersections between the corrected unit application route E11 and the segmentation lines of the application area sub-segments Q111 to 114 are denoted by G1, G2, and G3, and intersections between a line B6-C5 and the segmentation lines of the application area sub-segments Q111 to 114 are denoted by F1, F2, and F3.

The difference value between the start-side width Y(A9) - Y(B6) and the end-side width Y(A13) - Y(F1) of a first start-side application area sub-segment Q111 is calculated. The correction amount is calculated from this difference value and the reference correction amount set in S104. Then, the application amount is calculated by applying the calculated correction amount to the application amount ((Y(A9)-Y(B6)) * (X(A13)-X(A9)) *(application height H)) for the application area sub-segment Q111 under the assumption that the start-side width Y(A9) - Y(B6) is unchanged and constant from a start point D12 to an end point G1. The movement speed of the discharge device 102 is calculated for the application area sub-segment Q111 from this calculated application amount, the discharge amount per unit time set in S103, and the length D12-G1 of the application route.

Similarly, for each of a second application area sub-segment Q112, a third application area sub-segment Q113, and a fourth application area sub-segment Q114, the movement speed of the discharge device 102 is calculated, and the application parameter is corrected.

The application parameter is adjusted so as to realize the movement speed of the discharge device 102 calculated for each of the application area sub-segments Q111 to 114.

### • Corrected Unit Application Route E15

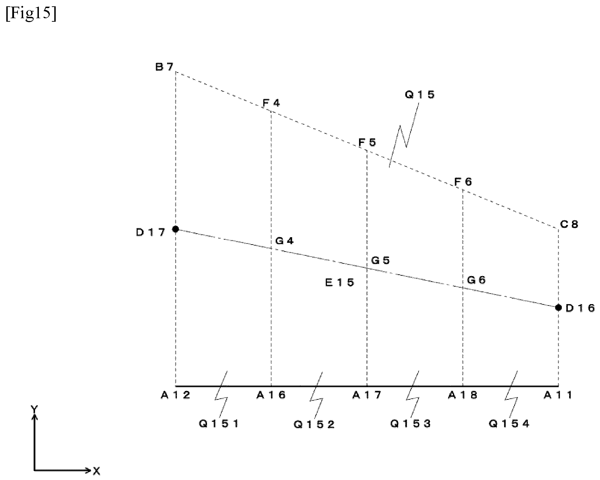

Fig. 15 is an enlarged view of an application area segment Q15 corresponding to the corrected unit application route E15.

The application area segment Q15 is segmented in a direction perpendicular to a side A11-A12 of the recess into four sub-segments such that their widths in the X-direction are the same. The four sub-segments created by the segmentation are referred to as application area sub-segments Q151 to 154. Herein, intersections between the side A11-A12 of the recess 201 and respective segmentation lines are denoted by A16, A17, and A18, intersections between the corrected unit application route E15 and the segmentation lines of the application area sub-segments Q151 to 154 are denoted by G4, G5, and G6, and intersections between a line B7-C8 and the segmentation lines of the application area sub-segments Q151 to 154 are denoted by F4, F5, and F6. The difference value between the start-side width Y(B7) - Y(A12) and the end-side width Y(F4) - Y(A16) of a first start-side application area sub-segment Q151 is calculated. The correction amount is calculated from this difference value and the reference correction amount set in 104. Then the application amount is calculated by applying the calculated correction amount to the application amount ((Y(B7)-Y(A12)) * (X(A16)-X(A12)) *(application height H)) for the application area sub-segment Q151 under the assumption that the start-side width Y(B7) - Y(A12) is unchanged and constant from a start point D17 to an end point G4. The movement speed of the discharge device 102 is calculated for the application area sub-segment Q151 from this calculated application amount, the discharge amount per unit time set in S103, and the length D17-G4 of the application route, and the application parameter is corrected.

Similarly, for each of a second application area sub-segment Q152, a third application area sub-segment Q153, and a fourth application area sub-segment Q154, the movement speed of the discharge device 102 is calculated, and the application parameter is corrected.

The application parameter is adjusted so as to realize the movement speed of the discharge device 102 calculated for each of the application area sub-segments Q151 to 154.

In this embodiment, although an application area segment is segmented into four application area sub-segments, any number of application area sub-segments may be created. Further, segmentation may be performed with a width in the X-direction changed for each application area sub-segments, instead of an equal width in the X-direction.

The procedure for correcting an application route can be described as segmenting one application area segment into a plurality of application area sub-segments, calculating the amount of the liquid material required for each application area sub-segment, and setting application parameters (the movement speed and the discharge amount per unit time of the discharge device) for applying that amount.

According to the procedure described above, even when the installation position misalignment of the components 202, 203 has caused the application area to have wide and narrow portions or the like, by setting the application amount in units of the application area segments and the application area sub-segments, it is possible to perform application such that the application area made up of gaps of complicated shapes is filled with the liquid material without excess or shortage.

### (2-5) Carrying Out Application Work (S505)

Application work is carried out along the application route corrected in S503, while the discharge device 102 is moved at the movement speed corrected in S504. This allows performing filling with the liquid material without excess or shortage even when installation position misalignment of components 202, 203 has caused a difference in the width of an application area segment.

### (2-6) Carrying Out Application Work on Pre-Application Workpiece (S506)

Until the application work is completed for all boards (workpieces) 111 as targets of the work, the procedures from S501 to S505 are performed on each board. If a board type, a liquid material type, or the like is changed, the application method is executed again from the initial setting in (1).

According to the present invention described above, it is possible to perform filling with liquid material without excess or shortage even in a case where an application area is made up of gaps of complicated shapes having a bend, wide and narrow portions, or the like due to position misalignment of components 202, 203 installed in a recess 201 of a board 111 or a profile tolerance of the components 202, 203 or the recess 201.

From another perspective, even when components are installed with misalignment in a recess, filling with liquid material can be performed accordingly, which eliminates the need for a high-precision component-mounting device, so that equipment costs can be saved. In addition, it is possible to reduce products treated as defective due to installation position misalignment of components, so that yields can be improved.

In this embodiment, two components are installed in a recess of a board in the illustrated example. However, even in a case where installed components are three or more, application can be carried out with similar setting and correction.

In this embodiment, the type of the discharge device is not particularly limited. Examples of available types include: a jet type in which discharge is performed by the action of a rod reciprocating in a liquid chamber; a screw type in which discharge is performed by the action of a screw rotating in a liquid chamber; a plunger type in which discharge is performed by the action of a plunger sliding in a measuring unit; and an air type in which discharge is performed by the action of pressurized gas. In these discharge devices, a discharge adjustment parameter for setting or adjusting a discharge amount per unit time may be: for the jet type, the number of times of discharge per unit time (or the number of times of rod reciprocation, which are sometimes referred to as "frequency"); for the screw type, a rotation speed of the screw; for the plunger type, a movement speed of the plunger; and for the air type, pressure application time.

### <Application Apparatus>

The application apparatus 101 for implementing the liquid application method according to this embodiment will be described.

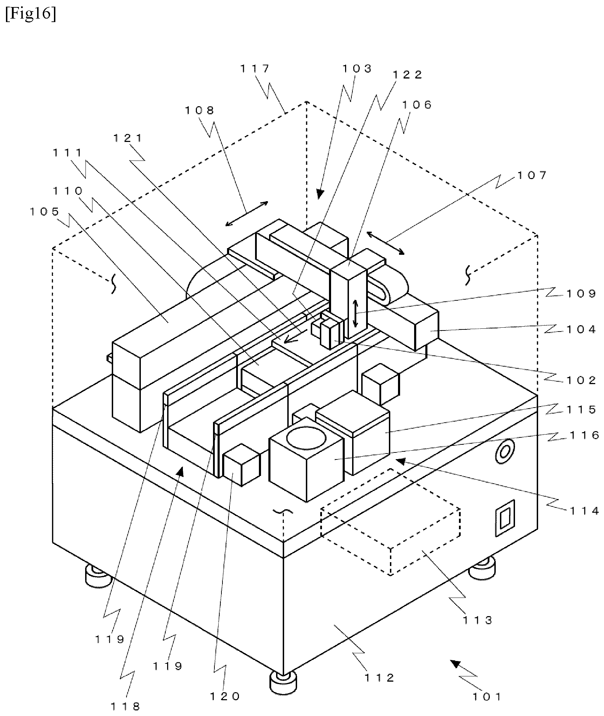

As illustrated in Fig. 16, the application apparatus 101 according to this embodiment includes: the discharge device 102 that discharges liquid material; and a relative driving device 103 that moves a worktable 110, on which a board 111 is placed, and the discharge device 102 relative to each other.

The relative driving device 103 includes an X-driving device 104, a Y-driving device 105, and a Z-driving device 106 that move the discharge device 102 and the worktable 110 relative to each other in an X-direction 107, a Y-direction 108, and a Z-direction 109, respectively. In this embodiment, the Y-driving device 105 extends in the Y-direction 108 on an upper surface of a housing 112, and the X-driving device 104 extends in the X-direction 107 on the Y-driving device 105. The Z-driving device 106 is provided on the X-driving device 104, and the discharge device 102 is provided on the Z-driving device 106. This configuration allows the discharge device 102 and a board 111 on the worktable 110 to move relative to each other in the X-direction 107, the Y-direction 108, and the Z-direction 109. The relative driving device 103 can move a nozzle tip of the discharge device 102 to any position over the board 111 at any speed under control of the control device 113. Examples of devices that can be used as the relative driving device 103 include: a combined device of an electric motor, such as a servomotor or a stepping motor, and a ball screw; a device using a linear motor; and a device using a belt or a chain to transmit power.

The discharge device 102 includes a nozzle (not illustrated) having a discharge port at its tip for discharging the liquid material, and operation thereof is controlled by the control device 113. The control device 113 can control the discharge device 102 in conjunction with operation of the relative driving device 103. The discharge device 102, which is moved by the relative driving device 103 so that the nozzle is located above a recess 201 of a workpiece 111, discharges the liquid material toward the recess 201 from the discharge port opening downward. The control device 113 will be described in detail below.

The application apparatus 101 according to this embodiment includes a transport device 118. The transport device 118 includes a rail 119, a transmission element (not illustrated), and a transport driving device 120. The rail 119 includes two members extending parallel in the Y-direction 108. The rail 119 is installed such that the distance between the two members is the same as a length of one side of a board 111. The rail 119 is provided with the transmission element that acts to transport the board 111 along the extending direction of the rail 119. A belt, a chain, or the like can be used as the transmission element. The transmission element is driven by the transport driving device 120. An electric motor such as a servomotor or a stepping motor can be used as the transport driving device 120. By the action of the transmission element driven by the transport driving device 120, the board 111 is transported in a transport direction 121 along the rail 119. The transport device 118 is connected to the control device 113, which controls a transport speed, start and stop of transport, and the like.

The worktable 110 including a rectangular parallelepiped member can be lifted and lowered by a lifting and lowering device (not illustrated). The worktable 110 is installed between the rail members 119 of the transport device 118. A width of the worktable 110 in the X-direction 107 is slightly smaller than the distance between the rail members 119 of the transport device 118 so as not to come into contact with the rail members 119 of the transport device 118. When a board 111 is transported, the worktable 110 is lowered to a position where it does not come into contact with the board 111. When the application work is performed on a board 111, the worktable 110 is lifted so that the board 111 can be fixed between the worktable 110 and a retaining plate (not illustrated) provided on the rail 119. In order to more securely fix a board 111, this mechanism may be used together with, for example, a mechanism that sucks and fixes the board 111 by sucking the air through a plurality of holes leading from an inside of the worktable 110 to an upper surface thereof.

The application apparatus 101 according to this embodiment includes the image capturing device 122. The image capturing device 122 is provided on the Z-driving device 106 together with the discharge device 102, and can be moved relative to a board 111 on the worktable 110. The image capturing device 122 can capture images of not only feature portions of a board 111 (that is, corners of a recess 201 of a board 111 and components 202, 203) but also identification marks on the board 111 or applied liquid material. For example, a CCD camera, a CMOS camera, or the like can be used as the image capturing device 122. The image capturing device 122 is connected to the control device 113, which can control operation thereof and can store and process image capturing results.

In addition to this, the application apparatus 101 may include a ranging device (not illustrated) for distance measurement. The ranging device can measure a distance to a surface of a board 111, a surface of a component installed on a board 111, or a surface of the liquid material applied to a board 111. The heights of a component and applied liquid material can be obtained from these measured values. For example, a laser displacement meter, an ultrasonic range finder, or the like can be used as the ranging device. The image capturing device 122 and the ranging device may be integrally provided via a mounting plate to be movable relative to a board 111. The ranging device is connected to the control device 113, and the control device 113 can control operation thereof, store measurements, and perform arithmetic processing on the measurements.

The application apparatus 101 according to this embodiment includes a calibration device 114. The calibration device 114 is installed near the worktable 110 on the upper surface of the housing 112 within a movement range of the relative driving device 103. The calibration device 114 includes a calibration table 115 and a weighing instrument 116. The calibration table 115 includes a trial application area to which the liquid material can be applied. The liquid material is applied to this trial application area, and a shape and a size of the applied liquid material are checked with the image capturing device and the ranging device. Based on the results, adjustment can be made to ensure the liquid material is applied to a board 111 in a desired shape and size. Instead of the calibration table 115, a plate-like body with a trial application area to which the liquid material can be applied may be separately prepared and fixed by the above-described suction and fixation mechanism, thereby forming the trial application area. The weighing instrument 116 can measure the mass/weight of the liquid material applied to a weighing pan. A weight scale, an electronic balance, or the like can be used as the weighing instrument 116. The weighing instrument 116 is connected to the control device 113, and the control device 113 can control operation thereof, store measurements, and perform arithmetic processing on the measurements. The weighing instrument 116 can measure the discharge amount per unit time of the discharge device 102.

The control device 113 is an information processing apparatus (computer) including a processing device, a storage device that stores the application program and the like, and a communication device, and is communicably connected to an input device and an output device. In this embodiment, a touch panel (not illustrated) is used as both the input device and the output device. A personal computer (PC), a programmable logic controller (PLC), or the like can be used as the control device 113. A keyboard, a mouse, and a display can be used as the input device and the output device.

The application apparatus 101 according to this embodiment can be connected to an instruction terminal not illustrated. With the instruction terminal, it is possible to give instructions on positioning of the relative driving device 103, the operation of the discharge device 102, and the like. The application apparatus 101 can sequentially set a plurality of related instructions to execute them as a sequence of instructions. In other words, the application apparatus 101 can operate the discharge device 102 and the relative driving device 103 according to the instructions. Examples of available instruction terminals include: a dedicated terminal including a simple display device and a plurality of switches; and a personal computer with dedicated software installed. With the instruction terminal, it is possible to start and stop the operation of the application apparatus 101 based on the application program stored in the control device 113. Instead of the instruction terminal, the above-described control device 113 and the touch panel can be used to give instructions.

Further, the application program includes means or steps for executing the setting/correction of an application route (S102, S503), the setting/correction of application parameters (S103, S504), and the application work (S505). By the control device 113 executing the application program, the following means or steps are realized: a position acquisition means for (or position acquisition step of) acquiring position coordinates of components 202, 203 disposed with gaps in a recess 201; an application route setting means for (or application route setting step of) setting, based on the acquired position coordinates, an application area and an application route for the discharge device 102 to perform application; an application parameter setting means for (or application parameter setting step of) segmenting the application route into application route segments and setting an application amount for each application route segment; and an application means for (or application step of) applying liquid material to the application area while moving the discharge device 102 along the application route.

A top of the housing 112, on which the discharge device 102, the relative driving device 103, the worktable 110, and the like are provided, is covered by a cover 117 represented by dotted lines. In Fig. 16, part of the line is not drawn for convenience of explanation. By providing the cover 117, it is possible to prevent dust from entering the application apparatus 101, and prevent careless contact between an operator and a moving portion of the relative driving device 103 or the like. Although not illustrated, the cover 117 may have an openable door for the operator to easily access the application apparatus 101. The above-described touch panel may be provided on the cover 117 so that the application apparatus can also be operated from outside the cover 117. Further, the cover 117 may be provided with an opening for a board 111 to be transported into or out of the application apparatus 101.

In the application apparatus, the application step is executed as follows:
(a) a pre-application board having a recess in which a plurality of components have been installed is transported into the application apparatus and fixed on the worktable 110;
(b) application is carried out according to the application method described above; and
(c) the board on which application has been performed is transported out of the application apparatus.

One basic cycle is as described above, and when there is a pre-application board left, (a) to (c) is repeated.

A following step may be added to the above cycle. For example, after carrying out the application work, there may be added a checking step of capturing a state of applied liquid material and determining whether the state is fine.

According to the application apparatus 101 of the embodiment described above, even in a case where a recessed application area has a bend, wide and narrow portions, or the like due to installation position misalignment of components 202, 203 or a profile tolerance of the components 202, 203 or a recess 201, it is possible to set an application route aligned with the shape of the application area and perform application to fill the application area made up of gaps of complicated shapes with liquid material without excess or shortage. For example, in a manufacturing process of a camera module or the like to be mounted on a smartphone, variation in installation positions of semiconductor elements as components results in wide and narrow portions in gaps (application area) between an inner wall surface of a recess provided in a board and outer peripheries of the components (see Fig. 12). When these gaps (application area) are filled with liquid material, there are issues that shortage of the liquid material causes inadequate fixation of the components and excess of the liquid material adversely affects the components. There is another issue that it is necessary to prevent the liquid material from flowing onto the top surface of the board or the components because it would affect quality. Especially in a camera module, if the liquid material flows onto the top surface of a semiconductor element and adheres thereto, a lens or the like to be mounted later would also be adversely affected. According to the present invention, these issues can be solved since an application area made up of gaps between an inner wall surface of a recess and outer peripheries of components can be filled with an appropriate amount of liquid material.

Although preferred embodiment examples of the present invention have been described above, the technical scope of the present invention is not limited to the descriptions of the above embodiment examples. Various alterations and modifications can be applied without departing from the technical idea of the present invention, and such altered or modified modes also fall within the technical scope of the present invention.

In the above embodiment, correction is performed by setting the reference correction amount (S104) and taking the correction amount into account during correction of application parameters (S504). However, it is not always necessary to set the reference correction amount. That is, without setting the reference correction amount, the movement speed of the discharge device 102 may be calculated during correction of application parameters (S504) by executing the same procedure as that for setting initial application parameters (S103).

In the above embodiment, during correction of an application route (S503), the movement speed of the discharge device 102 is corrected with the discharge amount per unit time of the discharge device fixed at a constant value. Alternatively, the discharge amount per unit time of the discharge device 102 may be corrected with the movement speed of the discharge device 102 fixed at a constant value. Particularly, in a case where the discharge device is the jet type, the volume or the mass/weight of one droplet may be adjusted instead of the discharge amount per unit time.

Further, a part of an application area segment may be filled with liquid material by so-called point application that is performed with the discharge device 102 stationary at a specific application position. In this case, it is disclosed that the application amount is corrected using duration of the discharge device 102 being stationary at the specific application position as the discharge adjustment parameter.

### List of Reference Symbols

101: application apparatus / 102: discharge device / 103: relative driving device / 104: X-driving device / 105: Y-driving device / 106: Z-driving device / 107: X-movement direction / 108: Y-movement direction / 109: Z-movement direction / 110: worktable / 111: board (workpiece) / 112: housing / 113: control device / 114: calibration device / 115: calibration table / 116: weighing instrument / 117: cover / 118: transport device / 119: rail / 120: transport driving device / 121: transport direction / 122: image capturing device (camera) / 201: recess / 202: first component / 203: second component / 204: liquid material / A, B, C, D, F, G: feature point (corner, midpoint, intersection) / E: application route / Q: application area / H: application height

## Claims

1. An application method for filling, with liquid material, an application area made up of a gap between an inner wall surface of a recess of a workpiece and an outer periphery of a component disposed in the recess, the application method comprising:
a position acquisition step of acquiring position coordinates of the component based on a captured image including a feature portion of the component;
an application route setting step of setting, based on the position coordinates, an application area and an application route for a discharge device to perform application;
an application parameter setting step of segmenting the application route of the discharge device into application route segments based on the position coordinates and setting an application amount for each application route segment; and
an application step of applying the liquid material to the application area while moving the discharge device along the application route.

2. The application method according to claim 1, wherein, in the application route setting step, the application area is segmented into application area segments and the application route segment is set for each application area segment.

3. The application method according to claim 2, wherein the component is one of a plurality of components disposed at intervals in the same recess, and
the application area includes a portion between the plurality of components.

4. The application method according to claim 2, wherein the recess has a polygonal shape as viewed from above,
the component has a polygonal shape as viewed from above, and
in the position acquisition step, position coordinates of all corners of the component and position coordinates of corners of the recess close to each corner of the component are acquired.

5. The application method according to claim 4, wherein, in the application route setting step, the application area is segmented into application area segments of which vertices include corners of the component.

6. The application method according to claim 4, wherein, in the application route setting step, the application area is segmented into a plurality of application area segments made up of quadrangles.

7. The application method according to claim 4, wherein, in the application route setting step, the application route is set with a straight route passing through a middle point of a width of the application area segment in a direction perpendicular to a traveling direction of the application route.

8. The application method according to claim 2, comprising an initial setting step of setting an initial application area, an initial application route, an initial application amount, and a reference correction amount, executed prior to the position acquisition step,
wherein, in the application parameter setting step, the application amount is set for each application area segment based on an application amount calculated based on a shape of the application area segment and the reference correction amount.

9. The application method according to any one of claims 2 to 8, wherein, in the application parameter setting step, in a case where a width of the application area segment in a direction perpendicular to a traveling direction of the application route is different between a start point and an end point, the application area segment is segmented into application area sub-segments, and an application amount is set for each application area sub-segment.

10. The application method according to any one of claims 2 to 8, wherein, in the application parameter setting step, the application amount is set by, with a discharge amount per unit time of the discharge device kept constant, setting a relative movement speed between the discharge device and the workpiece for each application area segment.

11. The application method according to any one of claims 2 to 8, wherein, in the application parameter setting step, the application amount is set by setting any one or more of following [A] to [D]:
[A] in a case where the discharge device is a jet-type discharge device, a number of times of discharge per unit time;
[B] in a case where the discharge device is a screw-type discharge device, a rotation speed of a screw;
[C] in a case where the discharge device is a plunger-type discharge device, a movement speed of a plunger; and
[D] in a case where the discharge device is an air-type discharge device, pressure application time.

12. The application method according to any one of claims 2 to 8, wherein the component is a semiconductor element.

13. The application method according to any one of claims 2 to 8, wherein, in the application route setting step, an application height is set to a height that does not reach a top end of either of the recess and the component.

14. The application method according to any one of claims 1 to 8, wherein, in the position acquisition step, position coordinates of the recess are further acquired based on a captured image including a feature portion of the recess, and
in the application parameter setting step, the application route of the discharge device is segmented into application route segments based on the position coordinates of the recess and the component, and an application amount is set for each application route segment.

15. An application apparatus comprising:
a discharge device configured to discharge liquid material;
a worktable on which a workpiece having a recess is placed;
a relative driving device configured to move the discharge device and the worktable relative to each other;
an image capturing device configured to capture an image including a feature portion of a component disposed with a gap in the recess of the workpiece; and
a control device configured to control operation of the discharge device, the relative driving device, and the image capturing device, wherein
the control device includes: a position acquisition means configured to acquire position coordinates of the component based on the captured image;
an application route setting means configured to set an application route of the discharge device based on the position coordinates;
an application parameter setting means configured to segment the application route of the discharge device into application route segments based on the position coordinates and set an application amount for each application route segment; and
an application means configured to apply the liquid material to the gap while moving the discharge device along the application route.

16. The application apparatus according to claim 15, wherein the application route setting means is configured to segment an application area based on the position coordinates into application area segments, and set the application route segment for each application area segment.

17. The application apparatus according to claim 16, wherein the application parameter setting means is configured to, in a case where a width of the application area segment in a direction perpendicular to a traveling direction of the application route is different between a start point and an end point, segment the application area segment into application area sub-segments, and set an application amount for each application area sub-segment.

18. The application apparatus according to any one of claims 15 to 17, further comprising a ranging device configured to measure a distance to the workpiece or the component.

19. The application apparatus according to any one of claims 15 to 17, further comprising a calibration device including a trial application area and a weighing instrument.
